# EUROPEAN PATENT APPLICATION

(11) **EP 4 658 023 A1**
(43) Date of publication of application: **03.12.2025**
(21) Application number: 25178579.6
(22) Date of filing: 23.05.2025
(51) Int. Cl.: H10D 89/60

(54) **INTEGRATED POWER DEVICE WITH OVERVOLTAGE PROTECTION**

(30) Priority: 28.05.2024 IT 202400012121
(71) Applicant: STMicroelectronics International N.V., 1228 Plan-les-Ouates, Geneva (CH)
(72) Inventor: PATTI, Davide Giuseppe, 95030 Mascalucia (CT) (IT)
(74) Representative: Studio Torta S.p.A.

(57) **Abstract**

An integrated power device includes: a die (5) containing a heterostructure (16); a main High Electron Mobility Transistor (HEMT) (2) at least partly formed in the heterostructure (16) and having a main source terminal (2a), a main drain terminal (2b) and a main gate terminal (2c); and an overvoltage protection circuit (3) coupled between the main source terminal (2a) and the main gate terminal (2c) of the main HEMT (2). The overvoltage protection circuit (3) includes at least one protection HEMT (7.1, 7.2, ..., 7.N.1, 7.N) at least partly formed in the heterostructure (16) .

## Description

### Technical Field

The present invention relates to an integrated power device with overvoltage protection.

### Background

High Electron Mobility Transistors or HEMTs have characteristics that make them increasingly suitable and widespread in fast-switching and high-power applications. These features include the ability to operate at high voltages and high breakdown voltage, with values up to several hundred Volts, as well as the high density and mobility of charge carriers.

In a HEMT, a semiconductor heterostructure (typically based on layers of AlGaN/GaN, gallium aluminum nitride/gallium nitride) allows a so-called 2-dimensional electron gas (2DEG) to be spontaneously generated in the device, effectively forming a conductive channel for electric charges. The spontaneous channel may be modulated, in use, by applying suitable voltages to a gate region of the device through a gate electrode.

However, the gate region is relatively fragile due to material properties and is sensitive to overvoltage. In gallium arsenide HEMTs, for example, voltages of a few hundred millivolts above the manufacturer's recommended gate voltage may cause irreversible damage.

To overcome this issue, the most common solutions include very high-precision driving circuits for the gate terminal and overvoltage protection networks between the gate and source terminals.

The driving circuits may be designed to achieve the desired performances, but the complexity needed to suppress the risk of overvoltage translates into a high cost, which is not always sustainable.

Protection networks comprise external components, generally discrete components, which offer but may limit the performance of HEMTs, especially with regards to switching speed. The benefit obtainable may not compensate for the performance loss, also because it is precisely the switching speed that makes HEMTs particularly appreciated for many applications.

### Summary

It is therefore the aim of the present invention to provide an integrated power device with overvoltage protection that allows the limitations described to be overcome or at least mitigated.

According to the present invention, an integrated power device with overvoltage protection is provided as defined in claim 1.

### Brief Description of the Figures

For a better understanding of the present invention, preferred embodiments are provided, by way of non-limiting example, with reference to the attached drawings, wherein:
- Figure 1 is a simplified electric diagram of an integrated power device in accordance with an embodiment of the present invention;
- Figure 2 is a first cross-section through the integrated device of Figure 1;
- Figure 3 is a second cross-section through the integrated device of Figure 1;
- Figure 4 is a simplified electric diagram of an integrated power device in accordance with a different embodiment of the present invention;
- Figure 5 is a simplified electric diagram of a first variant of the integrated device of Figure 4;
- Figure 6 is a simplified electric diagram of a second variant of the integrated device of Figure 4;
- Figure 7 is a top-plan view, with parts removed for clarity, of the integrated device of Figure 4; and
- Figure 8 is a cross-section through the integrated device of Figure 7, taken along the line VIII-VIII of Figure 7.

### Description of Embodiments

The following description refers to the arrangement shown in the drawings; consequently, expressions such as "above", "below", "upper", "lower", "top", "bottom", "right", "left" and similar relate to the attached Figures and are not to be interpreted in a limiting manner.

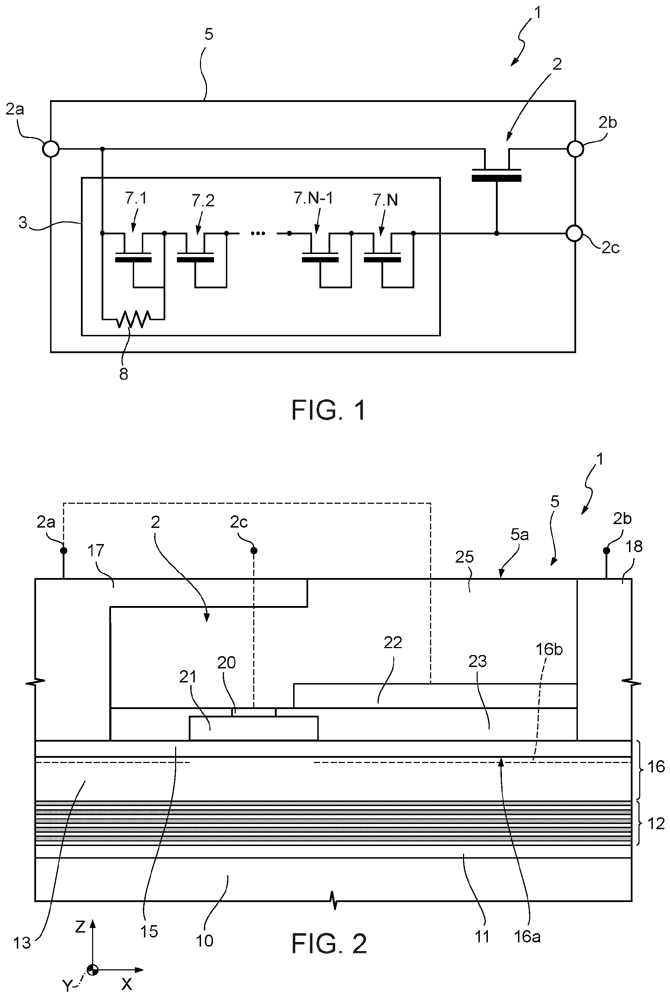

With reference to Figure 1, an integrated power device with overvoltage protection in accordance with an embodiment of the present invention is indicated by the number 1 and comprises a main High Electron Mobility Transistor or HEMT 2, having a main source terminal 2a, a main drain terminal 2b and a main gate terminal 2c, and an overvoltage protection circuit 3 (hereinafter simply protection circuit 3) integrated into a semiconductor die 5.

The protection circuit 3 is coupled between the main source terminal 2a and the main gate terminal 2c of the main HEMT 2 and comprises a plurality of protection HEMTs 7.1, 7.2, ..., 7.N-1, 7.N that are diode-connected in series with each other. More precisely, a first end protection HEMT 7.1 has a local source terminal connected to the main source terminal 2a of the main HEMT 2 and a second end protection HEMT 7.N has a local drain terminal connected to the main gate terminal 2c of the main HEMT 2. The intermediate protection HEMTs 7.2, ..., 7.N-1 between the first end protection HEMT 7.1 and the second end protection HEMT 7.N have the respective source terminal connected to the drain terminal of the adjacent HEMT in the series. Furthermore, all protection HEMTs 7.1, 7.2, ..., 7.N-1, 7.N have the respective gate and drain terminals directly connected to each other, as mentioned in a diode configuration. A protection resistor 8 is connected between the gate terminal and the source terminal of the first end protection HEMT 7.1 (in practice, in parallel with the first end protection HEMT 7.1).

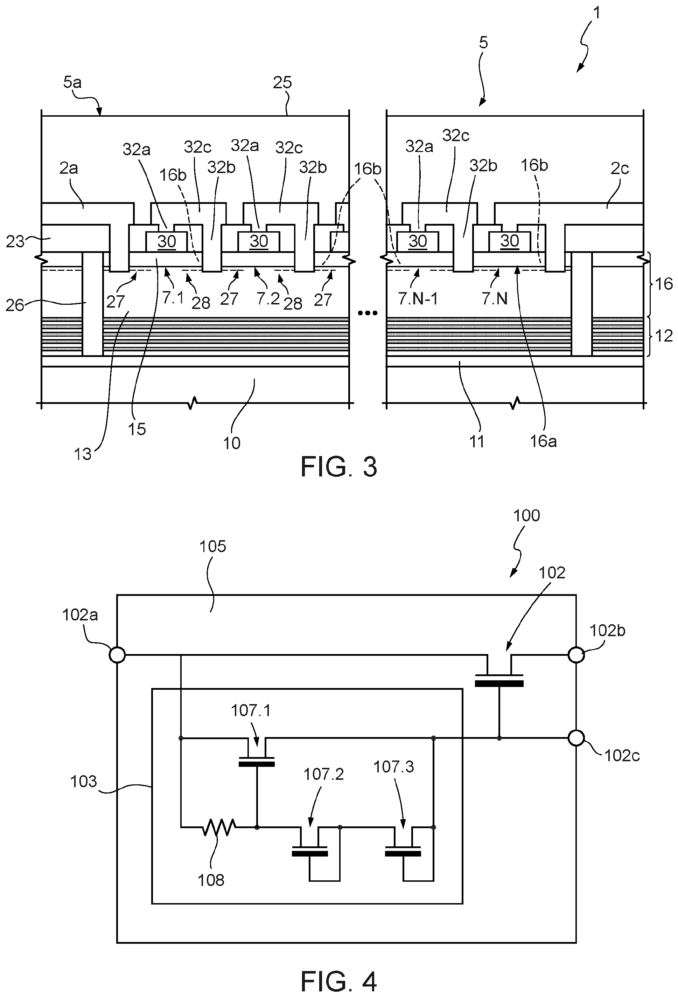

In the non-limiting embodiment illustrated in Figures 2 and 3, the die 5 comprises a substrate 10, which may be for example of monocrystalline silicon with mechanical support functions and possibly electric functions, an optional structural layer 11 of aluminum nitride, a transition multilayer structure 12, also optional, a channel layer 13 and a barrier layer 15.

The channel layer 13 and the barrier layer 15 are of respective semiconductor materials with different band gaps and form a heterostructure 16, with a heterojunction 16a at a common interface. For example, the channel layer 13 is of intrinsic gallium nitride (GaN), while the barrier layer 15 is of aluminum gallium nitride (AlGaN) and has N-type conductivity. A 2-dimensional electron gas (2DEG) 16b is formed in a channel region of the channel layer 13 at the heterojunction 16a.

Also shown in Figure 2 is the main HEMT 2, which, in one embodiment, is a normally-off enhancement HEMT and comprises a source metallization structure 17, a drain metallization structure 18 and a gate metallization structure 20, respectively coupled to the main source terminal 2a, to the main drain terminal 2b and to the main gate terminal 2c. The main HEMT 2 further comprises a gate region 21 of gallium nitride doped to have p-type conductivity (pGaN) and a source field plate 22. The gate region 21 extends over the barrier layer 15 and the gate metallization structure 20 in turn extends over the gate region 21. In the absence of voltage on the main gate terminal 2c, the 2-dimensional electron gas 16b is interrupted in a region of the channel layer 13 corresponding to the gate region 21 and the HEMT 2 is turned off.

The source field plate 22 is connected (in a manner not illustrated in the Figures) to the source metallization structure 17 and extends over the barrier layer 15 between the gate metallization structure 20 and the drain metallization structure 18. An insulating structure 23 separates the source field plate 22 from the barrier layer 15 and incorporates the gate region 21 of the main HEMT 2. A protective layer 25 of dielectric material, for example silicon oxide, covers the source field plate 22 and the insulating structure 23.

Figure 3 illustrates in more detail the protection circuit 3 with the protection HEMTs 7.1, 7.2, ..., 7.N-1, 7.N arranged adjacent to each other in succession along a first axis X between the main source terminal 2a and the main gate terminal 2c of the main HEMT 2. An insulation trench 26, which extends in depth through the heterostructure 16 and the transition multilayer structure 12 up to the structural layer 11, surrounds and separates the protection circuit 3 from the rest of the die 5.

In one embodiment, the protection HEMTs 7.1, 7.2, ..., 7.N-1, 7.N are identical to each other and each comprise a source region 27, a drain region 28 and a gate region 30. The gate regions 30 are arranged on the barrier layer 15 and extend parallel to each other and uniformly spaced. The source region 27 and the drain region 28 of each protection HEMT 7.1, 7.2, ..., 7.N-1, 7.N are defined in the heterostructure 16 on opposite sides of the respective gate region 30.

The integrated power device 1 also comprises metal coupling structures 32 which, in each protection HEMT 7.1, 7.2, ..., 7.N-1, 7.N, connect the respective drain region 28 and the respective gate region 30 directly to each other. Furthermore, the coupling structures 32 connect the source region 27 and the drain region 28 of intermediate protection HEMTs 7.2, ..., 7.N-1 directly adjacent to each other.

In more detail, each coupling structure 32 has a first contact strip 32a, a second contact strip 32b and a bridge 32c that connects the first contact strip 32 and the second contact strip 32b directly to each other.

The first contact strip 32a runs parallel to a front face 5a of the die 5, along a second axis Y perpendicular to the first axis X, and extends in depth (i.e. along a third axis Z perpendicular to the front face 5a of the die 5, to the first axis X and to the second axis Y) up to be in contact with the gate region 30 of the respective protection HEMT 7.1, 7.2, ..., 7.N-1, 7.N. In practice, the first contact strip 32a defines the local gate terminal of the respective protection HEMT 7.1, 7.2, ..., 7.N-1, 7.N.

The second contact strip 32b is parallel to the first contact strip 32a and extends in depth along the third axis Z through the barrier layer 15 up to be in contact with the channel layer 13. In one embodiment, the second contact strip 32b may slightly penetrate inside the barrier layer 15. The second contact strip 32b geometrically separates and electrically connects the drain region 28 of the respective protection HEMT 7.1, 7.2, ..., 7.N-1, 7.N and the source region 27 of the adjacent protection HEMT 7.1, 7.2, ..., 7.N-1, 7.N, which are maintained at the same voltage. In the first end protection HEMT 7.1, the source region 27 is directly connected to the main source terminal 2a of the main HEMT 2; in the second end protection HEMT 7.N, the respective coupling structure 32 connects the drain region 28 and the gate region 30 directly to the main gate terminal 2c of the main HEMT 2. In practice, the second contact strip 32b defines the local drain terminal of the respective protection HEMT 7.1, 7.2, ..., 7.N-1, 7.N and the local source terminal of the adjacent protection HEMT 7.2, ..., 7.N-1, 7.N.

The bridge 32c connects the respective first contact strip 32a and second contact strip 32b parallel to a front face 5a of the die 5.

According to a different embodiment of the invention, illustrated in Figure 4, an integrated power device with overvoltage protection 100 comprises a main HEMT 102, for example identical to the main HEMT 2 of Figures 1 and 2, and an overvoltage protection circuit 103 (hereinafter simply protection circuit 1003) integrated into a semiconductor die 105.

The protection circuit 103 is coupled between the main source terminal 102a and the main gate terminal 102c of the main HEMT 102 and comprises a first protection HEMT 107a and at least a second protection HEMT 107b. In the example of Figure 4, in particular, the protection circuit 103 comprises two second protection HEMTs 107b that are diode-connected and in series with each other along a first axis X'.

The first protection HEMT 107a has a local source terminal and a local drain terminal respectively connected to a main source terminal 102a and to a main drain terminal 102b of the main HEMT 102. A protection resistor 108 is connected between the local gate terminal and the local source terminal of the first protection HEMT 107a (in practice, in parallel with the first protection HEMT 107a).

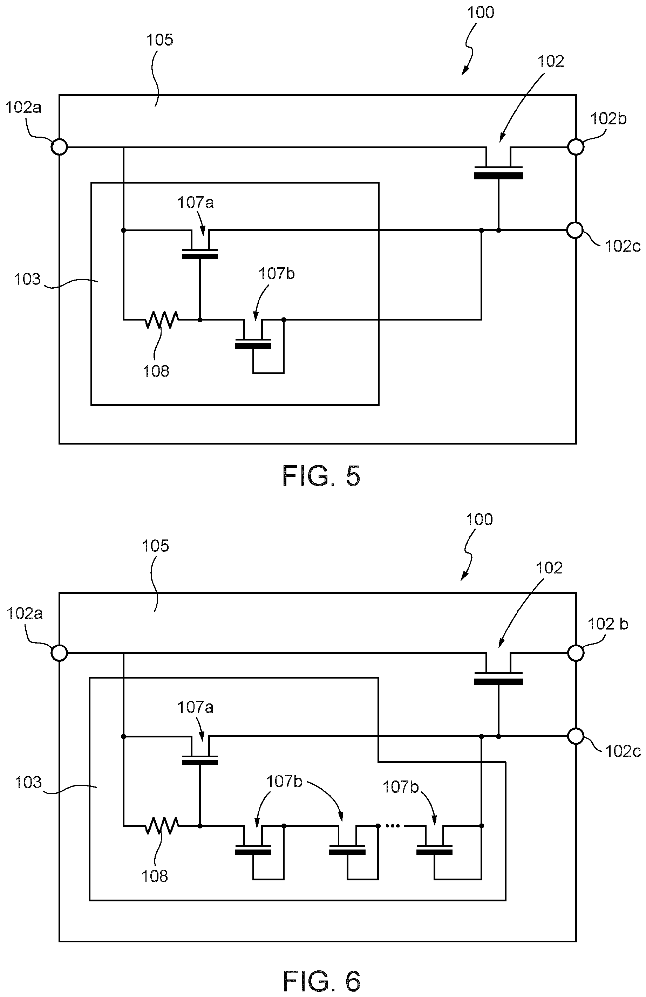

The series of second protection HEMTs 107b has a local source terminal and a local gate terminal connected respectively to the local gate terminal and the local drain terminal of the first protection HEMT 107a. In the example of Figure 4, with two second protection HEMTs 107b, and in the variant of Figure 5, with more than two second protection HEMTs 1007b in series, the second protection HEMTs 107b at the opposite ends of the series have one the local source terminal connected to the local gate terminal of the first protection HEMT 107a and the other the local drain terminal connected to the local drain terminal of the first protection HEMT 107a. In the variant of Figure 6, the protection circuit comprises a single second protection HEMT, with local source and drain terminals respectively connected to the local gate and drain terminals of the first protection HEMT 107a.

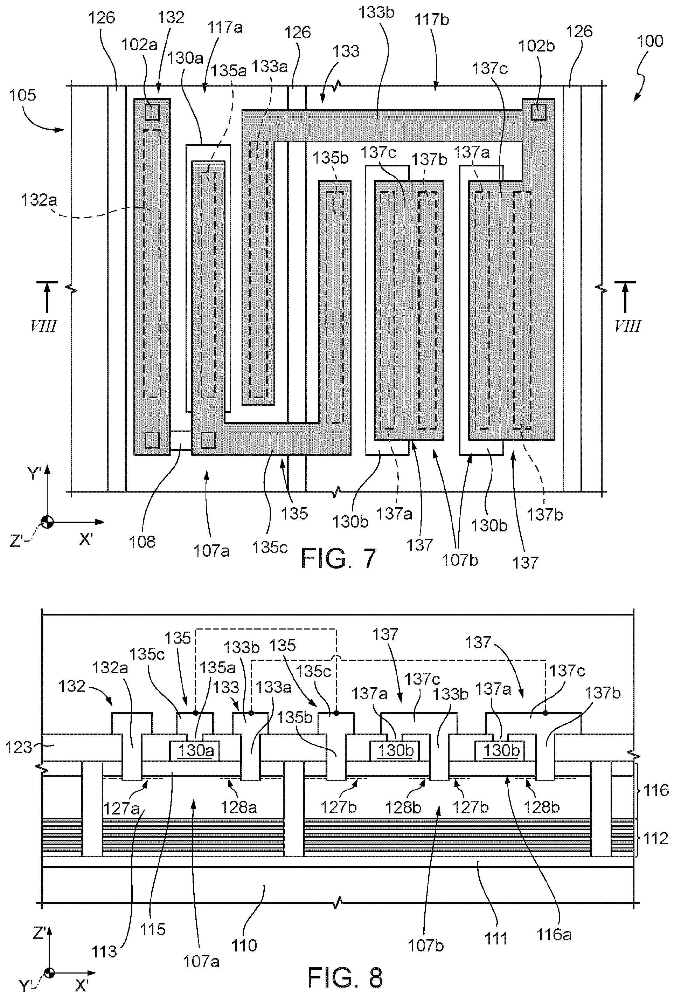

Figures 7 and 8 illustrate the die 105 of the device 100 of Figure 4 according to one embodiment. The die 105 has substantially the same structure already described for the die 5 of Figure 3 and comprises a substrate 110 of monocrystalline silicon, a structural layer 111 of aluminum nitride, a transition multilayer structure 112, also optional, a channel layer 113 and a barrier layer 115. The channel layer 113 and the barrier layer 115 form a heterostructure 116, with a heterojunction 116a at a common interface.

Insulation trenches 126 delimit a first protection active area 117a and a second protection active area 117b in the heterostructure 116 and extend through the underlying structures (here the transition multilayer structure 112) up to the structural layer 111. The first protection active area 117a accommodates the first protection HEMT 107a and the second protection active area 117b accommodates the second protection HEMTs 107b. Figures 7 and 8 also show a first source region 127a, a first drain region 128a and a first gate region 130a of the first protection HEMT 107a in the first protection active area 117a; second source regions 127b, second drain regions 128b and second gate regions 130b of the second protection HEMT 107b in the second protection active area 117b; and an insulating structure 123 incorporating the gate regions 130a, 130b of the protection HEMTs 107a, 107b. The source regions 127a, 127b, the drain regions 128a, 128b and the gate regions 130a, 130b extend along a second axis Y' parallel to a front face 105a of the die 105 and perpendicular to the first axis X' and are also arranged side by side along the first axis x'.

The protection HEMTs 107a, 107b are connected to each other by metal coupling structures, provided partly on the insulating structure 123, partly through the same insulating structure 123 and partly through the barrier layer 115.

A first coupling structure 132 is arranged on the insulating structure 123 and is connected to the main source terminal 102a of the main HEMT 102. The first coupling structure 132 comprises a contact strip 132a that extends in depth along a third axis Z' perpendicular to the first axis X' and to the second axis Y' up to be in contact with the first source region 127a.

A second coupling structure 133 comprises a contact strip 133a that extends in a direction parallel to the third axis Z' up to the channel layer 113, in contact with the first source region 127a; and in a direction parallel to the second axis Y' substantially for the length of the first source region 127a. Above the insulating structure 123, the second coupling structure 133 further comprises a bridge 133b that connects the contact strip 133a to the main drain terminal 102b. The bridge 133b has a first portion that extends in a direction parallel to the second axis Y' over the first drain region 128a and the contact strip 133a and a second portion that extends in a direction parallel to the first axis X' and is connected to the main drain terminal 102b.

A third coupling structure 135 comprises a first contact strip 135a, a second contact strip 135b and a bridge 135c that connects the first contact strip 135a and the second contact strip 135b to each other. The first contact strip 135a extends in a direction parallel to the second axis Y' in contact with the first gate region 130a. The second contact strip 135b extends in a direction parallel to the third axis Z' up to the channel layer 113, in contact with the second source region 127b; and in a direction parallel to the second axis Y' substantially for the length of the second source region 127b. The bridge 135c has first portions parallel to the second axis Y', having the first contact strip 135a and the second contact strip 135b extending therefrom, and a second portion parallel to the first axis X', which connects the first portions to each other by overpassing the insulation trench 126 between the first protection active area 117a and the second protection active area 117b.

Fourth coupling structures 137, one for each second protection HEMT 107b, each comprise a first contact strip 137a, a second contact strip 137b, and a bridge 137c that connects the respective first contact strip 137a and second contact strip 137b to each other. The first contact strips 137a extend in a direction parallel to the second axis Y' in contact with the second gate region 130b of the respective second protection HEMT 107b. The second contact strips 137b extend in a direction parallel to the third axis Z' up to the channel layer 113, in contact with the second drain regions 128b of the respective second protection HEMTs 107b; and in a direction parallel to the second axis Y' substantially for the length of the respective second drain regions 128b. The bridges 138c connect the respective first contact strips 137a and second contact strips 137b to each other over the insulating structure 123. The fourth coupling structure 137 of the second protection HEMT 107b farthest from the first protection HEMT 107a is also connected to the main drain terminal 102b of the main HEMT 102.

According to the invention, the protection circuit is advantageously provided using components that may be integrated into the same die in which the main HEMT is formed. The protection circuit is in fact substantially formed by HEMTs and metal coupling structures. The HEMTs may be manufactured at the same time as the main HEMT using the same heterostructure and the coupling structures may be formed by the metallization levels of the die. With a protection circuit integrated into the die of the main HEMT an effective protection may therefore be obtained without the need for external components or complex driving circuits, to the full advantage of the frequency performances of the HEMT.

Even from a manufacturing point of view, the protection circuit components may be obtained without additional manufacturing steps, exploiting the manufacturing process of the main HEMT and simply modifying some masks according to design preferences.

Finally, it is clear that modifications and variations may be made to the integrated device described and illustrated herein without thereby departing from the protective scope of the present invention, as defined in the attached claims.

For example, the number of protection HEMTs between the source and gate terminals of the main HEMT or of second protection HEMTs in series between the gate and drain terminals of the first protection HEMT may be chosen in accordance with design preferences and be different from those illustrated.

The coupling structure configuration, in addition to obviously being adaptable to the number of protection HEMTs present, may be modified based on the preferred layout of the device. In particular, the connections may have different paths than those illustrated.

## Claims

1. An integrated power device comprising:
a die (5; 105) containing a heterostructure (16; 116);
a main High Electron Mobility Transistor (HEMT) (2; 102) at least partly formed in the heterostructure (16; 116) and having a main source terminal (2a; 102a), a main drain terminal (2b; 102b) and a main gate terminal (2c; 102c); and
an overvoltage protection circuit (3; 103) coupled between the main source terminal (2a; 102a) and the main gate terminal (2c; 102c) of the main HEMT (2; 102);
wherein the overvoltage protection circuit (3; 103) comprises at least one protection HEMT (7.1, 7.2, ..., 7.N.1, 7.N; 107a, 107b) at least partly formed in the heterostructure (16; 116).

2. The device according to claim 1, wherein the die (5; 105) comprises a substrate (10; 110), a structural layer (11; 111), arranged between the substrate (10; 110) and the heterostructure (16; 116), and a trench insulation structure (26; 126), extending through the heterostructure (16; 116) to the structural layer (11; 111), wherein the trench insulation structure (26; 126) surrounds and separates the protective circuit (3) from the remainder of the die (5).

3. The device according to claim 1 or 2, wherein the overvoltage protection circuit (3) comprises a plurality of protection HEMTs (7.1, 7.2, ..., 7.N-1, 7.N) diode-connected in series with each other.

4. The device according to claim 3, wherein the protection HEMTs (7.1, 7.2, ..., 7.N-1, 7.N) each comprise a source region (27), a drain region (28) and a gate region (30); and wherein the source region (27) and the drain region (28) of each protection HEMT (7.1, 7.2, ..., 7.N-1, 7.N) are defined in the heterostructure (16) on opposite sides of the respective gate region (30) and preferably wherein the protection HEMTs (7.1, 7.2, ..., 7.N-1, 7.N) are identical to each other and the gate regions (30) are arranged on the barrier layer (15) and extend parallel to each other and uniformly spaced.

5. The device according to claim 3 or 4, comprising metal coupling structures (32) connecting, in each protection HEMT (7.1, 7.2, ..., 7.N-1, 7.N), the respective drain region (28) and the respective gate region (30) directly to each other and connecting the source region (27) and the drain region (28) of protection HEMTs (7.2, ..., 7.N-1) adjacent to each other.

6. The device according to claim 5, wherein each coupling structure (32) has a first contact strip (32a), a second contact strip (32b) and a bridge (32c) connecting the first contact strip (32) and the second contact strip (32b) directly to each other;
wherein the first contact strip (32a) of each coupling structure (32) is in contact with the gate region (30) of the respective protection HEMT (7.1, 7.2, ..., 7.N-1, 7.N);
wherein the heterostructure comprises a channel layer (13) and a barrier layer (15) and the second contact strip (32b) of each coupling structure (32) is parallel to the first contact strip (32a) and is in contact with the channel layer (13) and geometrically separates and electrically connects the drain region (28) of the respective protection HEMT (7.1, 7.2, ..., 7.N-1, 7.N) and the source region (27) of the adjacent protection HEMT (7.1, 7.2, ..., 7.N-1, 7.N).

7. The device according to claim 6, wherein, in each coupling structure (32), the first contact strip (32a) defines the local gate terminal of the respective protection HEMT (7.1, 7.2, ..., 7.N-1, 7.N) and the second contact strip (32b) defines the local drain terminal of the respective protection HEMT (7.1, 7.2, ..., 7.N-1, 7.N) and the local source terminal of the adjacent protection HEMT (7.2, ..., 7.N-1, 7.N).

8. The device according to any of claims 2 to 7, wherein the plurality of protection HEMTs (7.1, 7.2, ..., 7.N-1, 7.N) comprises a first end protection HEMT (7.1), having a local source terminal connected to the main source terminal (2a) of the main HEMT (2), and a second end protection HEMT (7.N), having a local drain terminal connected to the main gate terminal (2c) of the main HEMT 2.

9. The device according to claim 8, wherein the plurality of protection HEMTs (7.1, 7.2, ..., 7.N-1, 7.N) comprises at least one intermediate protection HEMT (7.2, ..., 7.N-1) coupled between the first end protection HEMT (7.1) and the second end protection HEMT (7.N) and having local source terminal connected to the local drain terminal of the protection HEMT (7.2, ..., 7.N-1, 7.N) adjacent in the series and having gate and drain terminals directly connected to each other.

10. The device according to any of claims 2 to 9, wherein the protection HEMTs (7.1, 7.2, ..., 7.N-1, 7.N) are arranged adjacent to each other in succession along an axis (X) between the main source terminal (2a) and the main gate terminal (2c) of the main HEMT (2).

11. The device according to claim 1 or 2, wherein the protection circuit (103) comprises a first protection HEMT (107a), having a local source terminal and a local drain terminal respectively connected to the main source terminal (102a) and to the main drain terminal (102b) of the main HEMT (102), and at least a second protection HEMT (107b) between the local gate terminal and the local drain terminal of the first protection HEMT (107a).

12. The device according to claim 11 as appended to claim 2, wherein the trench insulation structure comprises insulation trenches (126) delimiting a first protection active area (117a) and a second protection active area (117b) in the heterostructure (116), wherein the first protection active area (117a) accommodates the first protection HEMT (107a) and the second protection active area (117b) accommodates the at least a second protection HEMT (107b); wherein the first protection HEMT (107a) comprises a first source region (127a), a first drain region (128a) and a first gate region (130a) arranged side by side along a first axis (X') and extending along a second axis (Y') perpendicular to the first axis (X'); and wherein each second protection HEMT (107b) comprises a respective second source region (127b), a respective second drain region (128b) and a respective second gate region (130b) arranged side by side along the first axis (X') and extending along the second axis (Y').

13. The device according to claim 12, comprising:
a first coupling structure (132), connected to the main source terminal (102a) of the main HEMT (102) and comprising a respective contact strip (132a) in contact with the first source region (127a);
a second coupling structure (133), comprising a respective contact strip (133a), extending in a direction parallel to the second axis (Y') and in contact with the first source region (127a), and a respective bridge (133b) having a first portion extending in a direction parallel to the second axis (Y') over the first drain region (128a) and the respective contact strip (133a) and a second portion extending in a direction parallel to the first axis (X') and connected to the main drain terminal (102b);
a third coupling structure (135), comprising a respective first contact strip (135a), extending in a direction parallel to the second axis (Y') in contact with the first gate region (130a), a respective second contact strip (135b), extending in a direction parallel to the second axis (Y') and in contact with the second source region (127b), and a respective bridge (135c), connecting the respective first contact strip (135a) and the respective second contact strip (135b) to each other, the respective bridge (135c) having first portions parallel to the second axis (Y'), having the respective first contact strip (135a) and the respective second contact strip (135b) extending therefrom, and a second portion parallel to the first axis (X') and connecting the first portions to each other across the insulation trench (126) between the first protection active area (117a) and the second protection active area (117b); and
a fourth coupling structure (137) for each second protection HEMT (107b), each fourth coupling structure (137) comprising a respective first contact strip (137a), extending in a direction parallel to the second axis (Y') and in contact with the second gate region (130b) of the respective second protection HEMT (107b), a respective second contact strip (137b), extending in a direction parallel to the second axis (Y') and in contact with the second drain regions (128b) of the respective second protection HEMT (107b), and a respective bridge (137c) connecting the respective first contact strip (137a) and the respective second contact strip (137b) to each other.

14. The device according to any of claims 11 to 13, wherein the protection circuit (103) comprises a plurality of second protection HEMTs (107b) that are diode-connected and in series with each other between the local gate terminal and the local drain terminal of the first protection HEMT (107a).

15. The device according to any of the preceding claims, comprising a protection resistor (8; 108) in parallel to the at least one protection HEMT (7.1; 107a) connected to the main source terminal (2a; 102a) of the main HEMT.
